# EUROPEAN PATENT SPECIFICATION

(11) **EP 1 434 098 B1**
(45) Date of publication and mention of the grant of the patent: **08.03.2006**
(21) Application number: 03079167.7
(22) Date of filing: 23.12.2003
(51) Int. Cl.: G03F 7/20, G21K 1/00, H05G 2/00

(54) **Contamination barrier with expandable lamellas**
Kontaminationsschutz mit ausdehnbaren Lamellen
Barrière contre la contamination avec lamelles expansibles

(30) Priority: 23.12.2002 EP 02080454; 13.01.2003 EP 03075086
(43) Date of publication of application: 30.06.2004
(73) Proprietor: ASML Netherlands B.V., 5504 DR Veldhoven (NL)
(72) Inventor: Bakker, Levinus Pieter, 5708 ZT Helmond (NL); Dierichs, Marcel Mathijs Theodore Marie, 5914 WR Venlo (NL); Freriks, Johannes Maria, 5508 VC Veldhoven (NL); Schuurmans, Frank Jeroen Pieter, 5551 XE Valkenswaard (NL); Vijfvinkel, Jakob, 5652 LH Eindhoven (NL); Box, Wilhelmus Josephus, 3941 Eksel (BE)
(74) Representative: van Westenbrugge, Andries

(56) References cited:
- WO-A-99/42904
- WO-A-02/054153

## Description

The invention relates to a contamination barrier for passing through radiation from a radiation source and for capturing debris coming from the radiation source, the contamination barrier comprising a number of lamellas extending in a radial direction from a main axis, each of the lamellas being positioned in a plane that contains the main axis.

Such a contamination barrier is known from, for example, the international patent application WO 02/054153. The contamination barrier is normally positioned in a wall between two vacuum chambers of a radiation system of a lithographic projection apparatus.

In a lithographic projection apparatus, the size of features that can be imaged onto a substrate is limited by the wavelength of projection radiation. To produce integrated circuits with a higher density of devices, and hence higher operating speeds, it is desirable to be able to image smaller features. Whilst most current lithographic projection apparatus employ ultraviolet light generated by mercury lamps or excimer lasers, it has been proposed to use shorter wavelength radiation in the range 5 to 20 nm, especially around 13 nm. Such radiation is termed extreme ultraviolet (EUV) or soft x-ray and possible sources include, for instance, laser-produced plasma sources, discharge plasma sources, or synchrotron radiation from electron storage rings. Apparatus using discharge plasma sources are described in: W. Partlo, I. Fomenkov, R. Oliver, D. Birx, "Development of an EUV (13.5 nm) Light Source Employing a Dense Plasma Focus in Lithium Vapor", Proc. SPIE 3997, pp. 136-156 (2000); M.W. McGeoch, "Power Scaling of a Z-pinch Extreme Ultraviolet Source", Proc. SPIE 3997, pp. 861-866 (2000); W.T. Silfvast, M. Klosner, G. Shimkaveg, H. Bender, G. Kubiak, N. Fomaciari, "High-Power Plasma Discharge Source at 13.5 and 11.4 nm for EUV lithography", Proc. SPIE 3676, pp. 272-275 (1999); and K. Bergmann et al., "Highly Repetitive, Extreme Ultraviolet Radiation Source Based on a Gas-Discharge Plasma", Applied Optics, Vol. 38, pp. 5413-5417 (1999).

EUV radiation sources may require the use of a rather high partial pressure of a gas or vapor to emit EUV radiation, such as discharge plasma radiation sources referred to above. In a discharge plasma source, for instance, a discharge is created between electrodes, and a resulting partially ionized plasma may subsequently be caused to collapse to yield a very hot plasma that emits radiation in the EUV range. The very hot plasma is quite often created in Xe, since a Xe plasma radiates in the Extreme UV (EUV) range around 13.5 nm. For an efficient EUV production, a typical pressure of 0.1 mbar is required near the electrodes to the radiation source. A drawback of having such a rather high Xe pressure is that Xe gas absorbs EUV radiation. For example, 0.1 mbar Xe transmits over 1 m only 0.3 % EUV radiation having a wavelength of 13.5 nm. It is therefore required to confine the rather high Xe pressure to a limited region around the source. To reach this, the source can be contained in its own vacuum chamber that is separated by a chamber wall from a subsequent vacuum chamber in which the collector mirror and illumination optics may be obtained. The chamber wall can be made transparant to EUV radiation by a number of apertures in the wall provided by a contamination barrier or so-called "foil trap" such as described in European Patent application number EP-A-1 057 079 corresponding to WO 99/42 904 A. In EP-A-1 057 079 a foil trap has been proposed to reduce the number of particles propagating along with the EUV radiation. This foil trap consists of a number of lamella shaped walls, which are close together in order to form a flow resistance but not too close as to let the radiation pass without substantially obstructing it. The lamellas can be made of very thin metal platelets, and are positioned near the radiation source. The lamellas are positioned in such a way, that diverging EUV radiation coming from a radiation source, can easily pass through, but debris coming from the radiation source is captured. Debris particles collide with gas inside the foil trap, are scattered thereby and eventually collide with the lamellas and stick to these lamellas.

The lamellas however absorb some EUV radiation and heat. Moreover, they are heated by colliding debris particles. This results in significant heating of the lamellas and a supporting structure which supports the lamellas. Since optical transmission is very important in a lithographic projection apparatus, mechanical deformation is not allowed. Therefore, it is an object of the present invention to provide a contamination barrier in which disadvantageous deformation of lamellas is minimized.

This object is achieved according to the present invention by a contamination barrier according to claim 1.

By slidably positioning one of the outer ends of a lamella, the lamella can expand in a radial direction without the appearance of mechanical tension which may create a deformation of the lamella.

Preferably the lamellas are thermally connected to at least one of the inner and outer ring. In this way, heat from the lamellas will be transported to the rings. Note that a thermal connection is not necessarily a mechanical connection; heat conduction from the lamellas to the rings is even possible when the connection is slidable. Furthermore, a connection using a heat conducting gel between the lamellas and the rings is thinkable.

In an embodiment the contamination barrier comprises a first shield arranged to protect the inner ring from being hit by radiation from the radiation source. In this way, the heating of the inner ring is limited. Preferably, the contamination barrier comprises a second shield arranged to block thermal radiation from the first shield. By blocking the heat radiation coming from the first heat shield, the beam going into the collector is not exposed by unwanted radiation.

In a further embodiment upstream of the first shield, with respect to the direction of propagation of the radiation emitted by the radiation source along the main axis, a third shield is provided, constructed and arranged to reduce heating of the first shield caused by direct radiation from the radiation source. The third shield prevents the first shield from being excessively heated by direct radiation from the radiation source, and consequently further reduces heat radiating from the first shield towards the collector.

In a preferred embodiment the contamination barrier also comprises at least one cooling spoke to support the first shield, wherein the cooling spoke is thermally connected to the outer ring. The cooling spoke can be made of metal or any other heat conductive material, like for example carbon. The cooling spoke not only supports the first shield, but also transports heat from the first heat shield to the outer ring.

In an embodiment the first shield comprises a number of shield members, each shield member being connected to the outer ring via a separate cooling spoke.

In a further embodiment, the contamination barrier comprises a first cooling means arranged to cool at least one of the first and second shield. In this case, a cooling spoke as described above is not necessary. The cooling means may comprise a cooling system in which a cooling fluid is used to remove the heat away from the contamination barrier. The cooling means may be part of a cooling system used in a collector. In this way, the cooling means will be in the shadow of the heat shields, and thus not blocking the EUV radiation beam. Preferably, the heat shields are supported by the cooling means. Vibrations coming from the cooling system will not reach the lamellas of the contamination barrier because the inner ring is not fixed to the cooling system.

In yet another embodiment the contamination barrier comprises a second cooling means arranged to cool the inner ring. If the inner ring is cooled directly, there will be no need for a heat shield.

In a further embodiment, the contamination barrier comprises a third cooling means arranged to cool the outer ring. If the lamellas are slidably connected to the inner ring and thermally connected to the outer ring, the heat from the lamellas will go to the outer ring. The outer ring can be easily cooled by for example water cooling, since it is outside the EUV optical path.

Preferably the lamellas are curved in the respective planes, and the inner and outer ring are shaped as slices of a conical pipe. If the surfaces of the outer and inner ring are focussed on the EUV source, the EUV beam will be blocked by the rings as little as possible. Only the inner ring will be in the way for the EUV beam, which is unavoidable. However, no light is lost, as the collector is unable to collect radiation in this solid angle anyway.

In a further embodiment, a first side of the lamellas, at least in use facing the radiation source, is thicker than the rest of the lamellas. If this way, the influence of minor warping of the lamellas is reduced. The warped lamellas should be positioned in the shadow of the thick front side of the lamellas. This measure results in better uniformity of the transmission of the contamination barrier.

The present invention also relates to a radiation system comprising a contamination barrier as described above, and a collector for collecting radiation passing the contamination barrier.

It is an object not forming part of the present invention to extend the lifetime of a collector of a radiation system. This relates to a radiation system comprising:
- a contamination barrier for passing through radiation from a radiation source and for capturing debris coming from the radiation source, the contamination barrier comprising a number of lamellas, and
- a collector for collecting radiation passing the contamination barrier,

characterized in that a surface of the lamellas is covered with the same material as an optical surface of the collector.
When material is sputtered off of the contamination barrier onto the collector, the life time of the collector is only minimally influenced if the materials are equal.
The invention also relates to a lithographic projection apparatus comprising:
- a support structure constructed and arranged to hold patterning means, to be irradiated by a projection beam of radiation to pattern the projection beam of radiation,
- a substrate table constructed and arranged to hold a substrate, and
- a projection system constructed and arranged to image an irradiated portion of the patterning means onto a target portion of the substrate,

wherein the projection apparatus comprises a radiation system according to claim 15 for providing a projection beam of radiation.

Finally the invention includes the method of claim 17.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the support structure may be embodied as a frame or table, for example, which may be fixed or movable as required; and
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an TC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including extreme ultra-violet (EUV) radiation (e.g. having a wavelength in the range 5-20 nm), as well as particle beams, such as ion beams or electron beams.

Embodiments of the invention will now be described, by way of example only, with reference to the accompanying drawings in which:
Fig. 1 schematically depicts a lithographic projection apparatus;
Fig. 2 shows a side view of a part of the apparatus of fig. 1 in an embodiment, i.e., an EUV illuminating system and projection optics;
Fig. 3 shows a foil trap with an inner and outer ring, and lamellas according to an embodiment of the invention;
Fig. 4 shows a foil trap with a cooling spoke and a heat shield;
Fig. 5 is a 3-D picture of an inner ring according to an embodiment of the invention;
Fig. 6 shows a detailed example of a lamella of a foil trap according to the invention.
Fig. 7 shows a foil trap with a cooling spoke and two heat shields; and
Fig. 8 shows alternative embodiment of a foil trap with a cooling spoke and two heat shields.

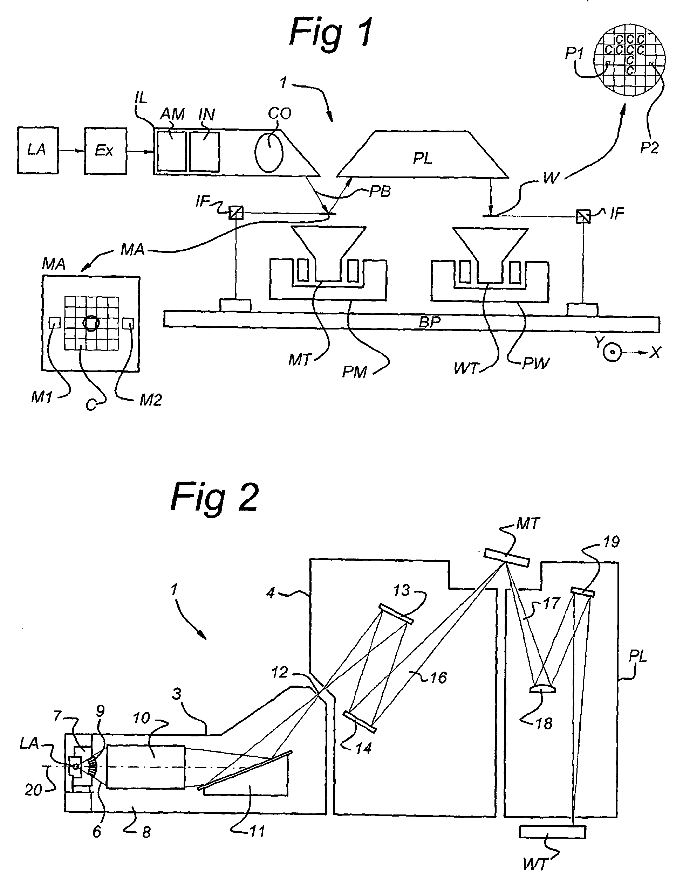

Figure 1 schematically depicts a lithographic projection apparatus 1 according to a particular embodiment of the invention. The apparatus comprises:
- a radiation system Ex, IL, for supplying a projection beam PB of radiation (e.g. EUV radiation) with a wavelength of 11-14 nm. In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. a laser-produced plasma or a discharge plasma EUV radiation source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO, see figure 1. In this way, the beam PB impinging on the mask MA has a desired uniformity and intensity distribution in its cross-section.

It should be noted with regard to figure 1 that the source LA may be within the housing of the lithographic projection apparatus, but that it may also be remote from the lithographic projection apparatus, the radiation beam which it produces being led into the apparatus (e.g. with the aid of suitable directing mirrors).

The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. in step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. in scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the projection system PL (typically, M = 1/4 or 1/5). In this manner, a relatively large target portion C can be exposed, without having to compromise on resolution.

Figure 2 shows an embodiment of the lithographic projection apparatus 1 of Figure 1, comprising a radiation system 3 (i.e. "source-collector module"), an illumination optics unit 4, and the projection system PL. The radiation system 3 is provided with a radiation source LA which may comprise a discharge plasma source. The radiation source LA may employ a gas or vapor, such as Xe gas or Li vapor in which a very hot plasma can be created to emit radiation in the EUV range of the electromagnetic spectrum. The very hot plasma is created by causing a partially ionized plasma of an electrical discharge to collapse onto an optical axis 20. Partial pressures of 0.1 mbar of Xe gas, Li vapor or any other suitable gas or vapor may be required for efficient generation of the radiation. The radiation emitted by the radiation source LA is passed from a source chamber 7 into a collector chamber 8 via a foil trap 9. The foil trap 9 comprises a channel structure such as, for instance, described in detail in European patent application EP-A-1 057 079 corresponding to WO 99/42 904 A.

The collector chamber 8 comprises a radiation collector 10 which may be formed by a grazing incidence collector. Radiation passed by the radiation collector 10 is reflected off a grating spectral filter 11 or mirror to be focused in a virtual source point 12 at an aperture in the collector chamber 8. From chamber 8, the projection beam 16 is reflected in the illumination optics unit 4 via normal incidence reflectors 13, 14 onto a reticle or mask positioned on reticle or mask table MT. A patterned beam 17 is formed which is imaged in projection optics system PL via reflective elements 18, 19 onto wafer stage or substrate table WT. More elements than shown may generally be present in illumination optics unit 4 and projection system PL.

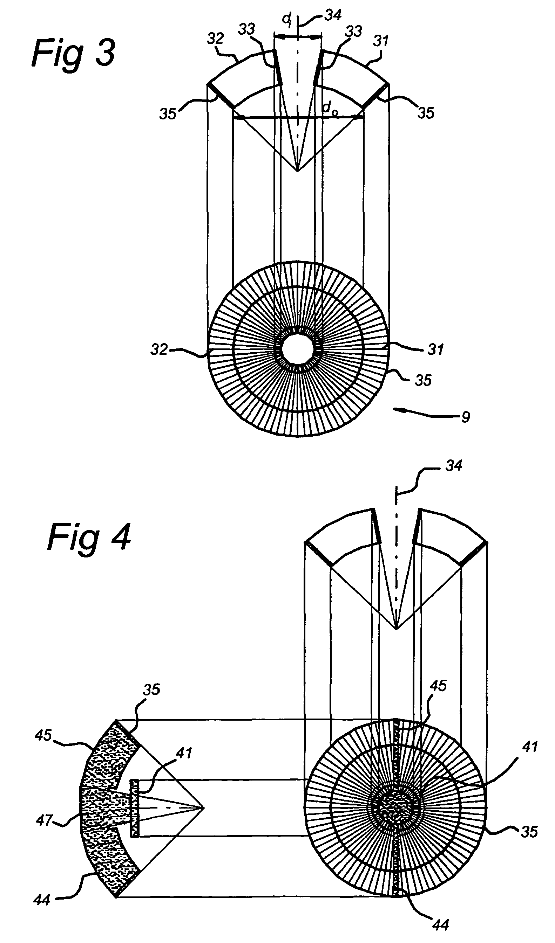

Figure 3 shows a downstream and a cross-sectional view, respectively, of a foil trap 9 with a plurality of lamellas 31, 32 according to an embodiment of the invention. The foil trap 9 comprises an inner ring 33 and an outer ring 35. Preferably, the inner ring 33 and the outer ring 35 are shaped as slices of a conical pipe, wherein a minimum diameter do of the outer ring 35 is larger than a minimum diameter dᵢ of the inner ring 33. Preferably, both conical rings 33, 35 share the same main axis 34 and focus. Preferably, the foil trap 9 is arranged in a lithographic projection apparatus, in such a way that the main axis 34 of the foil trap 9 and the optical axis 20 of the radiation system 3 coincide, see figure 2.

In figure 4 a foil trap 9 is shown which comprises a heat shield 41. The heat shield 41 is supported by two cooling spokes 44, 45 which are mechanically and thermally connected to the outer ring 35. At the center of the foil trap 9, the cooling spokes 44, 45 connect to a spindle 47, which supports the heat shield 41. The heat shield 41 comprises a disk, which avoids the inner ring 33 from being hit by the emitted radiation and heat from the radiation source LA. In this way, the heat shield 41 shields off the inner ring 33. The cooling spokes 44, 45, the spindle 47 and the heat shield 41 are preferably made of a good heat conductor. In this way, heat developed on the heat shield 41, may easily be transferred to the outer ring 35 via the cooling spokes 44, 45. Alternatively, the heat shield 41 may comprise two (or more) disc parts, each disc part being connected to one cooling spoke 44, 45. In this case, the spindle 47 will also be divided into two (or more) parts.

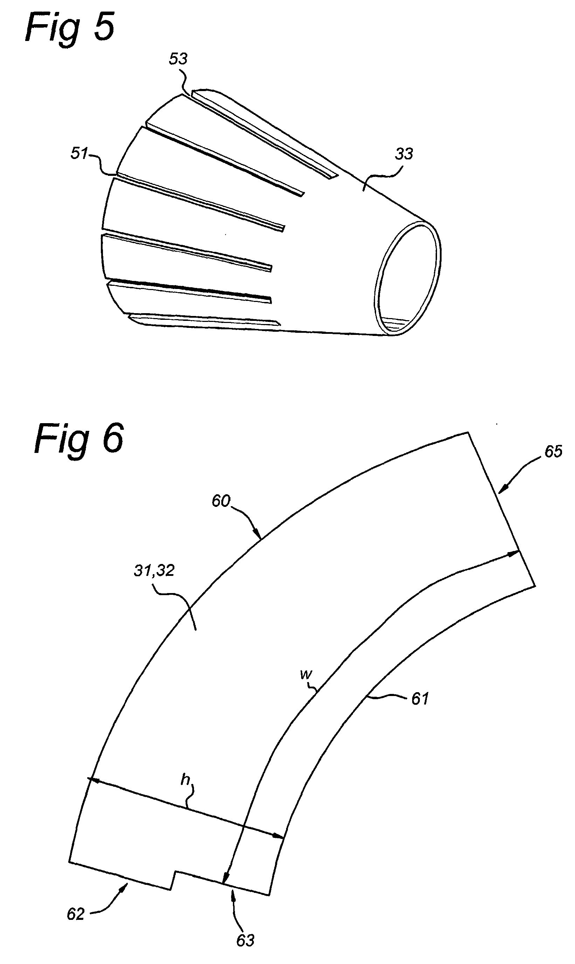

Figure 5 shows a bird view an the inner ring 33 according to an embodiment of the invention. The inner ring 33 comprises a plurality of grooves 51. Preferably, two grooves 53, opposite to one another, have a relative larger width than the other grooves. These larger grooves 53 are provided to pass the cooling spokes 44, 45.

The inner ring 33 is only supported mechanically by the plurality of lamellas 31, 32. It is not connected to anything else than the lamellas 31, 32.

Figure 6 shows a detailed example of a lamella 31, 32 of a foil trap 9 according to the invention. The lamella 31, 32 is a very thin platelet having two curved edges 60, 61, a straight outer edge 65, and an inner edge 62 having an indentation 63. The lamella 31, 32 has a height h and a width w, see figure 6. The outer edge 65 is mechanically connected to the outer ring 35, see figure 4. The inner edge 62 is inserted into one of the grooves 51 of the inner ring 33, see figure 5. Preferably, the lamellas 31, 32 are soldered or welded to the outer ring 35. In this way, a good thermal contact is provided and approximately all the heat absorbed by the lamellas, is transported to the outer ring 35. In one embodiment, the outer ring 35 is cooled by a cooling means, not shown, to remove the heat from the foil trap 9.

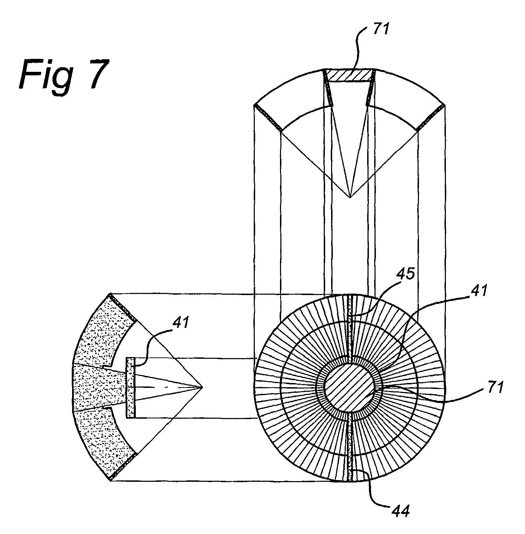

In an embodiment of the invention, the foil trap 9 also comprises a second heat shield in order to block thermal radiation from the first heat shield 41. Figure 7 shows a foil trap 9 with first and second heat shields 41, 71. In an embodiment, the second heat shield 71 comprises a disc, positioned inside the inner ring 33 and situated at the back end (i.e. down stream side) of this inner ring 33.

In another embodiment, the cooling spoke 44, 45 is absent. In this case, the first and/or second shields 41, 71 are cooled by cooling means, arranged in a way known by a person skilled in the art. The cooling means may comprise a water cooling system. This water cooling system can be part of a cooling system of the collector 10 of the radiation system 3. In this case, the shields 41, 71 are supported by the cooling means.

In yet another embodiment, the inner ring 33 is cooled by a cooling means. The cooling means for cooling the shields 41, 71 and the cooling means for cooling the inner ring 33, may be one. The foil trap 9 may be focussed on the radiation source 6. It is also possible to construct a foil trap 9 without a real focus. In any case, channels, i.e., spaces between adjacent lamellas, in the foil trap 9 have to be aligned with the emitted EUV beam. In figure 2, the foil trap 9 is focussed on the radiation source. Hereby EUV rays of radiation emitted from the EUV source may pass the lamellas 31, 32 without obstruction. Typical values for the dimensions of the lamellas are: height h = 30 mm, thickness 0.1 mm and width w = 50 mm (curved). A typical value for the channel width, i.e. the distance between adjacent lamellas, is 1 mm. The distance from the foil trap 9 to the source LA is typically in the order of 60 mm.

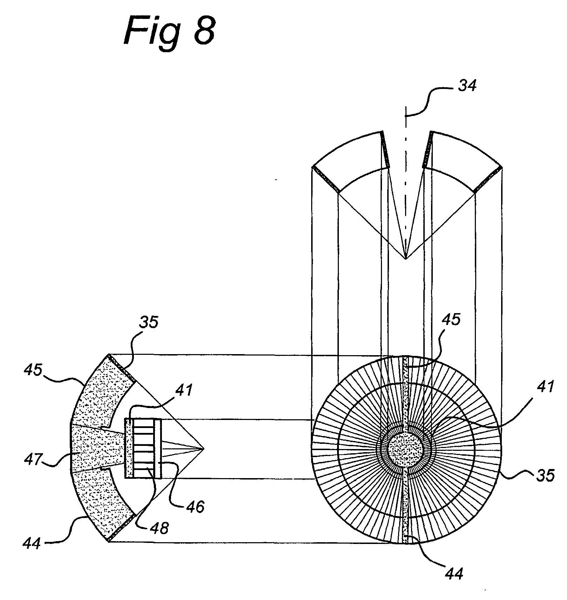

The embodiment of figure 8 is similar to the one shown in figure 4, except for the additional heat shield 46, mounted in front of shield 41. The additional shield 46 prevents the first shield 41 from being excessively heated by direct radiation from the radiation source LA, and consequently reduces heat radiating from the first shield 41 towards the collector 10. The additional heat shield 46 may be mounted on shield 41 using dedicated separation means 48 in order to accomplish substantially thermal isolation between the two shields. The separation means 48 may be manufactured e.g. from ceramics, which is able to resist the heat caused by the radiation impinging on the additional shield 46 and has a very small heat conduction coefficient. In another embodiment of the separation means 48 it may be envisaged that by special design of the separation means a heat resistance is created between the additional shield 46 and shield 41 considerably reducing heat transfer between the two shields.

While specific embodiments of the invention have been described above, it will be appreciated that the invention may be practiced otherwise then as described. The description is not intended to limit the invention, which is defined by the claims.

## Claims

1. A contamination barrier (9) for passing through radiation from a radiation source (LA) and for capturing debris coming from said radiation source, said contamination barrier comprising a number of lamellas (31, 32) extending in a radial direction from a main axis, each of said lamellas being positioned in a respective plane that comprises said main axis, **characterized in that** the contamination barrier comprises an inner ring (33) supported by said lamellas (31, 32) and an outer ring (35) connected to said lamellas (31, 32) and that an end of each of said lamellas is slidably positioned in a groove (51) in at least one of said inner and outer rings (33,35).

2. A contamination barrier according to claim 1, further **characterized in that** said lamellas (31, 32) are thermally connected to at least one of said inner and outer ring.

3. A contamination barrier according to any of the preceding claims, further **characterized in that** said contamination barrier comprises a first shield (41) arranged to protect said inner ring (33) from being hit by radiation from said radiation source (LA).

4. A contamination barrier according to claim 3, further **characterized in that** said contamination barrier comprises a second shield (71) arranged to block thermal radiation from said first shield (41).

5. A contamination barrier according to claim 3 or 4, further **characterized in that** upstream of the first shield (41) with respect to the direction of propagation of the radiation emitted by the radiation source (LA) along the main axis, a third shield (46) is provided, constructed and arranged to reduce heating of the first shield (41) caused by direct radiation from the radiation source.

6. A contamination barrier according to claim 5, further **characterized in that** said third shield (46) is substantially thermally isolated with respect to said first shield (41).

7. A contamination barrier according to claim 6, further **characterized in that** said third shield (46) is connected to said first shield (41).

8. A contamination barrier according to claim 3 to 7, further **characterized in that** said contamination barrier comprises at least one cooling spoke (44, 45) arranged to support said first shield (41), said at least one cooling spoke being thermally connected to said outer ring (35).

9. A contamination barrier according to claim 8, further **characterized in that** said first shield (41) comprises a number of shield members, each shield member being connected to said outer ring (35) via a separate cooling spoke (44, 45).

10. A contamination barrier according to claims 3-9, further **characterized in that** said contamination barrier comprises a first cooling means arranged to cool at least one of said first and second shield (41, 71).

11. A contamination barrier according to any of the preceding claims, further **characterized in that** said contamination barrier comprises a second cooling means arranged to cool said inner ring (33).

12. A contamination barrier according to any of the preceding claims, further **characterized in that** said contamination barrier comprises a third cooling means arranged to cool said outer ring (35).

13. A contamination barrier according to any of the preceding claims, further (**characterized in that** said lamellas (31, 32) are curved in said respective planes, and said inner and outer rings (33, 35) are shaped as slices of a conical pipe.

14. A contamination barrier according to any of the preceding claims, further **characterized in that** a first side of said lamellas (31, 32) at least in use facing the radiation source (LA), is thicker than the rest of said lamellas

15. A radiation system (Ex, IL) comprising:
- a contamination barrier (9) according to any of the preceding claims, and
- a collector (10) for collecting radiation passing said contamination barrier.

16. A lithographic projection apparatus comprising:
- a support structure (MT) constructed and arranged to hold patterning means (MA), to be irradiated by a projection beam (PB) of radiation to pattern said projection beam of radiation,
- a substrate table (WT) constructed and arranged to hold a substrate (W), and
- a projection system (PL) constructed and arranged to image an irradiated portion (C) of the patterning means onto a target portion (C) of the substrate (W),
wherein said projection apparatus comprises a radiation system (Ex, IL) according to claim 15 for providing a projection beam of radiation.

17. Method of manufacturing an integrated structure by a lithographic process comprising the steps of:
- providing a radiation systemic (Ex, IL) according to claim 15 to form a projection beam (PB) of radiation, from radiation emitted by a radiation source (LA),
- radiating said projection beam through said radiation system,,
- providing a support structure (MT) constructed and arranged to hold patterning means (MA) to be irradiated by the projection beam to pattern said projection beam,
- providing a substrate table (WT) constructed and arranged to hold a substrate (W),
- providing a projection system (PL) constructed and arranged to image an irradiated portion (C) of the patterning means onto a target portion (C) of the substrate.

## Patentansprüche

1. Kontaminationsbarriere (9) zum Durchlassen von Strahlung von einer Strahlungsquelle (LA) und zum Abfangen von Fragmenten, die von der Strahlungsquelle kommen, wobei die Kontaminationsbarriere eine Anzahl von Lamellen (31, 32) aufweist, die sich in einer Richtung von einer Hauptachse aus erstrecken, wobei jede der Lamellen in einer jeweiligen Ebene angeordnet ist, die die Hauptachse beinhaltet,
**dadurch gekennzeichnet,**
**daß** die Kontaminationsbarriere einen von den Lamellen (31, 32) abgestützten inneren Ring (33) und einen mit den Lamellen (31, 32) verbundenen äußeren Ring (35) aufweist,
und **daß** ein Ende von jeder der Lamellen in einer Nut (51) in mindestens einem von dem inneren und dem äußeren Ring (33, 35) verschiebbar angeordnet ist.

2. Kontaminationsbarriere nach Anspruch 1,
weiterhin **dadurch gekennzeichnet,**
**daß** die Lamellen (31, 32) in thermischer Verbindung mit mindestens einem von dem inneren und dem äußeren Ring stehen.

3. Kontaminationsbarriere nach einem der vorangehenden Ansprüche,
weiterhin **dadurch gekennzeichnet,**
**daß** die Kontaminationsbarriere eine erste Abschirmung (41) aufweist, die dazu angeordnet ist, den inneren Ring (33) vor dem Auftreffen von Strahlung von der Strahlungsquelle (LA) auf diesem zu schützen.

4. Kontaminationsbarriere nach Anspruch 3,
weiterhin **dadurch gekennzeichnet,**
**daß** die Kontaminationsbarriere eine zweite Abschirmung (71) aufweist, die zum Blockieren von Wärmestrahlung von der ersten Abschirmung (41) angeordnet ist.

5. Kontaminationsbarriere nach Anspruch 3 oder 4,
weiterhin **dadurch gekennzeichnet,**
**daß** stromaufwärts von der ersten Abschirmung (41) in bezug auf die Ausbreitungsrichtung der von der Strahlungsquelle (LA) entlang der Hauptachse emittierten Strahlung eine dritte Abschirmung (46) vorgesehen ist, die dazu ausgebildet und angeordnet ist, die durch direkte Strahlung von der Strahlungsquelle verursachte Erwärmung der ersten Abschirmung (41) zu reduzieren.

6. Kontaminationsbarriere nach Anspruch 5,
weiterhin **dadurch gekennzeichnet,**
**daß** die dritte Abschirmung (46) in bezug auf die erste Abschirmung (41) im wesentlichen thermisch isoliert ist.

7. Kontaminationsbarriere nach Anspruch 6,
weiterhin **dadurch gekennzeichnet,**
**daß** die dritte Abschirmung (46) mit der ersten Abschirmung (41) verbunden ist.

8. Kontaminationsbarriere nach einem der Ansprüche 3 bis 7,
weiterhin **dadurch gekennzeichnet,**
**daß** die Kontaminationsbarriere mindestens eine Kühlspeiche (44, 45) aufweist, die dazu angeordnet ist, die erste Abschirmung (41) abzustützen, wobei die mindestens eine Kühlspeiche mit dem äußeren Ring (35) in thermischer Verbindung steht.

9. Kontaminationsbarriere nach Anspruch 8,
weiterhin **dadurch gekennzeichnet,**
**daß** die erste Abschirmung (41) eine Anzahl von Abschirmelementen aufweist,
wobei jedes Abschirmelement mit dem äußeren Ring (35) über eine separate Kühlspeiche (44, 45) verbunden ist.

10. Kontaminationsbarriere nach einem der Ansprüche 3 bis 9,
weiterhin **dadurch gekennzeichnet,**
**daß** die Kontaminationsbarriere eine erste Kühleinrichtung aufweist, die zum Kühlen von mindestens einer von der ersten und der zweiten Abschirmung (41, 71) angeordnet ist.

11. Kontaminationsbarriere nach einem der vorangehenden Ansprüche,
weiterhin **dadurch gekennzeichnet,**
**daß** die Kontaminationsbarriere eine zweite Kühleinrichtung aufweist, die zum Kühlen des inneren Rings (33) angeordnet ist.

12. Kontaminationsbarriere nach einem der vorangehenden Ansprüche,
weiterhin **dadurch gekennzeichnet,**
**daß** die Kontaminationsbarriere eine dritte Kühleinrichtung aufweist, die zum Kühlen des äußeren Rings (35) angeordnet ist.

13. Kontaminationsbarriere nach einem der vorangehenden Ansprüche,
weiterhin **dadurch gekennzeichnet,**
**daß** die Lamellen (31, 32) in den jeweiligen Ebenen gekrümmt sind und der innere und der äußere Ring (33, 35) in Form von Segmenten eines konischen Rohrs ausgebildet sind.

14. Kontaminationsbarriere nach einem der vorangehenden Ansprüche,
weiterhin **dadurch gekennzeichnet,**
**daß** eine erste Seite der Lamellen (31, 32), die zumindest im Gebrauch der Strahlungsquelle (LA) zugewandt ist, dicker ist als der Rest der Lamellen.

15. Strahlungssystem (Ex, IL), die folgendes aufweist:
- eine Kontaminationsbarriere (9) nach einem der vorangehenden Ansprüche, und
- einen Kollektor (10) zum Sammeln von Strahlung, die durch die Kontaminationsbarriere hindurchgeht.

16. Lithographische Projektionsvorrichtung, die folgendes aufweist:
- eine Halterungskonstruktion (MT), die dazu ausgebildet und angeordnet ist, eine Strukturierungseinrichtung (MA) zu halten, die mit einem Strahlungs-Projektionsstrahl (PB) zu bestrahlen ist, um den Strahlungs-Projektionsstrahl zu strukturieren,
- einen Substrattisch (WT), der dazu ausgebildet und angeordnet ist, ein Substrat (W) zu halten, und
- ein Projektionssystem (PL), das dazu ausgebildet und angeordnet ist, einen bestrahlten Bereich (c) der Strukturierungseinrichtung auf einem Zielbereich (C) des Substrats (W) abzubilden,
wobei die Projektionsvorrichtung ein Strahlungssystem (Ex, IL) gemäß Anspruch 15 zum Bereitstellen eines Strahlungs-Projektionsstrahls aufweist.

17. Verfahren zum Herstellen einer integrierten Struktur durch einen lithographischen Prozeß, wobei das Verfahren folgende Schritte aufweist:
- Bereitstellen eines Strahlungssystems (Ex, IL) zum Bilden eines Strahlungs-Projektionsstrahls (PB) aus von einer Strahlungsquelle (LA) emittierter Strahlung,
- Abstrahlen des Projektionsstrahls durch das Strahlungssystem, gemäß Anspruch 15,
- Bereitstellen einer Halterungskonstruktion (MT), die dazu ausgebildet und angeordnet ist, eine Strukturierungseinrichtung (MA) zu halten, die mit dem Projektionsstrahl zu bestrahlen ist, um den Projektionsstrahl zu strukturieren,
- Bereitstellen eines Substrattisches (WT), der dazu ausgebildet und angeordnet ist, ein Substrat (W) zu halten, und
- Bereitstellen eines Projektionssystems (PL), das dazu ausgebildet und angeordnet ist, einen bestrahlten Bereich (C) auf einem Zielbereich (C) des Substrats (W) abzubilden.

## Revendications

1. Barrière contre la contamination (9) pour passer à travers des rayons provenant d'une source de rayonnement (LA) et pour capturer des dépôts provenant de ladite source de rayonnement, ladite barrière contre la contamination comprenant un certain nombre de lamelles (31, 32) s'étendant dans une direction radiale depuis un axe principal, chacune desdites lamelles étant positionnée dans un plan respectif qui comprend ledit axe principal, **caractérisée en ce que** la barrière contre la contamination comprend une bague intérieure (33) supportée par lesdites lamelles (31, 32) et une bague extérieure (35) reliée auxdites lamelles (31, 32) et **en ce qu'**une extrémité de chacune desdites lamelles est positionnée de manière coulissante dans une rainure (51) dans au moins une desdites bagues intérieure et extérieure (33, 35).

2. Barrière contre la contamination selon la revendication 1, **caractérisée en outre en ce que** lesdites lamelles (31, 32) sont thermiquement reliées à au moins une desdites bagues intérieure et extérieure.

3. Barrière contre la contamination selon l'une quelconque des revendications précédentes, **caractérisée en outre en ce que** ladite barrière contre la contamination comprend un premier écran de protection (41) agencé pour protéger ladite bague intérieure (33) en l'empêchant d'être touchée par les rayons provenant de ladite source de rayonnement (LA).

4. Barrière contre la contamination selon la revendication 3, **caractérisée en outre en ce que** ladite barrière contre la contamination comprend un deuxième écran de protection (71) agencé pour bloquer les rayons thermiques provenant dudit premier écran de protection (41) .

5. Barrière contre la contamination selon la revendication 3 ou 4, **caractérisée en outre en ce qu'**en amont dudit premier écran de protection (41), par rapport à la direction de propagation des rayons émis par la source de rayonnement (LA) le long de l'axe principal, est disposé un troisième écran de protection (46), construit et agencé pour réduire l'échauffement du premier écran de protection (41) causé par les rayons directs provenant de la source de rayonnement.

6. Barrière contre la contamination selon la revendication 5, **caractérisée en outre en ce que** ledit troisième écran de protection (46) est sensiblement thermiquement isolé par rapport audit premier écran de protection (41) .

7. Barrière contre la contamination selon la revendication 6, **caractérisée en outre en ce que** ledit troisième écran de protection (46) est relié audit premier écran de protection (41).

8. Barrière contre la contamination selon les revendications 3 à 7, **caractérisée en outre en ce que** ladite barrière contre la contamination comprend au moins un barreau de refroidissement (44, 45) agencé pour supporter ledit premier écran de protection (41), ledit au moins un barreau de refroidissement étant thermiquement relié à ladite bague extérieure (35).

9. Barrière contre la contamination selon la revendication 8, **caractérisée en outre en ce que** ledit premier écran de protection (41) comprend un certain nombre d'éléments d'écran de protection, chaque élément d'écran de protection étant relié à ladite bague extérieure (35) via un barreau de refroidissement séparé (44, 45).

10. Barrière contre la contamination selon les revendications 3-9, **caractérisée en outre en ce que** ladite barrière contre la contamination comprend un premier moyen de refroidissement agencé pour refroidir au moins un écran parmi lesdits premier et deuxième écrans de protection (41, 71).

11. Barrière contre la contamination selon l'une quelconque des revendications précédentes, **caractérisée en outre en ce que** ladite barrière contre la contamination comprend un deuxième moyen de refroidissement agencé pour refroidir ladite bague intérieure (33).

12. Barrière contre la contamination selon l'une quelconque des revendications précédentes, **caractérisée en outre en ce que** ladite barrière contre la contamination comprend un troisième moyen de refroidissement agencé pour refroidir ladite bague extérieure (35).

13. Barrière contre la contamination selon l'une quelconque des revendications précédentes, **caractérisée en outre en ce que** lesdites lamelles (31, 32) sont courbées dans lesdits plans respectifs, et **en ce que** lesdites bagues intérieure et extérieure (33, 35) sont formées comme des tranches d'un tuyau conique.

14. Barrière contre la contamination selon l'une quelconque des revendications précédentes, **caractérisée en outre en ce qu'**un premier côté desdites lamelles (31, 32) faisant face, au moins en utilisation, à la source de rayonnement (LA) est plus épais que le reste desdites lamelles.

15. Système de rayonnement (Ex, IL), comprenant :
- une barrière contre la contamination (9) selon l'une quelconque des revendications précédentes, et
- un collecteur (10) destiné à collecter les rayons passant ladite barrière contre la contamination.

16. Appareil de projection lithographique comprenant :
- une structure de support (MT) construite et agencée pour contenir un moyen de modelage (MA), à irradier par un faisceau de projection (PB) de rayonnement pour modeler ledit faisceau de projection de rayonnement,
- une table de substrat (WT) construite et agencée pour contenir un substrat (W), et
- un système de projection (PL) construit et agencé pour imager une partie irradiée (c) du moyen de modelage sur une partie cible (c) du substrat (W),
dans lequel ledit appareil de projection comprend un système de rayonnement (Ex, IL) selon la revendication 15 destiné à fournir un faisceau de projection de rayonnement.

17. Procédé de fabrication d'une structure intégrée par un procédé lithographique, comprenant les étapes consistant à :
- prévoir un système de rayonnement (Ex, IL) selon la revendication 15 pour former un faisceau de projection (PB) de rayonnement, à partir des rayons émis par une source de rayonnement (LA),
- émettre ledit faisceau de projection à travers ledit système de rayonnement,
- prévoir une structure de support (MT) construite et agencée pour contenir un moyen de modelage (MA) à irradier par le faisceau de projection pour modeler ledit faisceau de projection,
- prévoir une table de substrat (WT) construite et agencée pour contenir un substrat (W),
- prévoir un système de projection (PL) construit et agencé pour imager une partie irradiée (c) du moyen de modelage sur une partie cible (c) du substrat.
